# EUROPEAN PATENT SPECIFICATION

(11) **EP 3 714 013 B1**
(45) Date of publication and mention of the grant of the patent: **27.12.2023**
(21) Application number: 18879392.1
(22) Date of filing: 25.10.2018
(51) Int. Cl.: C09G 1/02, C09G 1/04, C09K 3/14, H01L 21/306, B24B 37/04, G11B 5/84

(54) **COMPOSITION AND METHOD FOR POLISHING MEMORY HARD DISKS EXHIBITING REDUCED SURFACE SCRATCHING**
ZUSAMMENSETZUNG UND VERFAHREN ZUM POLIEREN VON SPEICHERFESTPLATTEN MIT REDUZIERTEN OBERFLÄCHENKRATZERN
COMPOSITION ET PROCÉDÉ DE POLISSAGE D'UNITÉS DE DISQUES DURS À MÉMOIRE PRÉSENTANT UNE SURFACE RÉDUITE DE RAYURE

(30) Priority: 20.11.2017 US 201715817959
(43) Date of publication of application: 30.09.2020
(73) Proprietor: CMC Materials, Inc., Aurora, IL 60504 (US)
(72) Inventor: ZHANG, Ke, Aurora, Illinois 60504 (US)
(74) Representative: Barker Brettell LLP
(86) International application number: PCT/US2018/057478
(87) International publication number: WO 2019/099161

(56) References cited:
- EP-A1- 1 445 796
- US-A1- 2002 102 923
- US-A1- 2006 060 568
- US-A1- 2009 094 901
- US-A1- 2011 062 376
- US-A1- 2013 146 804
- US-A1- 2015 259 804
- US-A1- 2015 315 417

## Description

### BACKGROUND OF THE INVENTION

The demand for increased storage capacity in memory or rigid disks and the trend towards miniaturization of memory or rigid disks (due to the requirement for smaller hard drives in computer equipment) continues to emphasize the importance of the memory or rigid disk manufacturing process, including the planarization or polishing of such disks for ensuring maximal performance. While there exist several chemical-mechanical polishing (CMP) compositions and methods for use in conjunction with semiconductor device manufacture, few conventional CMP methods or commercially available CMP compositions are well-suited for the planarization or polishing of memory or rigid disks.

A two-step process can be used to polish memory or rigid disks. Following coating of aluminum with nickel-phosphorous using an electroless coating process, a first polishing step is carried out to planarize the disk surface, followed by a second polishing step to achieve a uniform surface. In this second polishing step, scratches and micro defects typically result from the action of abrasive particles, such as colloidal silica particles, present in polishing compositions used in the polishing step. Reduction in the size and number of scratch defects would allow for an increase in the areal density of the disk, and thus the recording capacity for a disk can be increased.

US 2015/315417 A1 discloses a CMP composition comprising: (a) an abrasive comprising wet-process silica particles, (b) a water-soluble polymer, (c) an oxidizing agent (hydrogen peroxide), (d) a chelating agent, (e) a pH-adjusting agent (nitric acid), and (1) an aqueous carrier, wherein the pH of the polishing composition is 1 to 7. The chemical-mechanical polishing composition is used for polishing substrate e.g. a nickel-phosphorus coated aluminum memory disk.

### BRIEF SUMMARY OF THE INVENTION

The invention provides a chemical-mechanical polishing composition comprising (a) wet-process silica, (b) a combination of (i) an alcohol of formula (I): R¹-X-(CH₂)ₘ-OH wherein R¹ is phenyl, pyridyl, HO-(CH₂)ₙ-, or C₁-C₆ alkyl, m is an integer from 1 to 6, n is an integer from 1 to 6, and X is absent or is O, and (ii) an alcohol of formula (II): R²-NR³-(CH₂)ₒ-OH wherein R² is phenyl, pyridyl, H₂N-(CH₂)ₚ-, or C₁-C₆ alkyl, R³ is hydrogen or C₁-C₆ alkyl, o is an integer from 1 to 6, and p is an integer from 1 to 6, (c) hydrogen peroxide, (d) a mineral acid, and (e) water, wherein the polishing composition has a pH from about 1 to about 5.

The invention also provides a method of chemically mechanically polishing a substrate comprising (i) providing a substrate, (ii) providing a polishing pad, (iii) providing a chemical-mechanical polishing composition comprising (a) wet-process silica, (b) a combination of (i) an alcohol of formula (I): R¹-X-(CH₂)ₘ-OH wherein R¹ is phenyl, pyridyl, HO-(CH₂)ₙ-, or C₁-C₆ alkyl, m is an integer from 1 to 6, n is an integer from 1 to 6, and X is absent or is O, and (ii) an alcohol of formula (II): R²-NR³-(CH₂)ₒ-OH wherein R² is phenyl, pyridyl, H₂N-(CH₂)ₚ-, or C₁-C₆ alkyl, R³ is hydrogen or C₁-C₆ alkyl, o is an integer from 1 to 6, and p is an integer from 1 to 6, (c) hydrogen peroxide, (d) a mineral acid, and (e) water, wherein the polishing composition has a pH from about 1 to about 5, (iv) contacting the substrate with the polishing pad and the chemical-mechanical polishing composition, and (v) moving the polishing pad and the chemical mechanical polishing composition relative to the substrate to abrade at least a portion of the substrate to polish the substrate.

The invention further provides a method of chemically mechanically polishing a substrate comprising (i) providing a substrate, (ii) providing a polishing pad, (iii) providing a chemical-mechanical polishing composition comprising (a) wet-process silica, (b) phenoxyethanol, ethylene glycol monobutyl ether, or benzyl alcohol, (c) hydrogen peroxide, (d) a mineral acid, and (e) water, wherein the polishing composition has a pH from about 1 to about 5, (iv) contacting the substrate with the polishing pad and the chemical-mechanical polishing composition, and (v) moving the polishing pad and the chemical mechanical polishing composition relative to the substrate to abrade at least a portion of the substrate to polish the substrate.

### DETAILED DESCRIPTION OF THE INVENTION

The invention provides a chemical-mechanical polishing composition comprising, consisting essentially of, or consisting of (a) wet-process silica, (b) a combination of (i) an alcohol of formula (I): R¹-X-(CH₂)ₘ-OH wherein R¹ is phenyl, pyridyl, HO-(CH₂)ₙ-, or C₁-C₆ alkyl, m is an integer from 1 to 6, n is an integer from 1 to 6, and X is absent or is O, and (ii) an alcohol of formula (II): R²-NR³-(CH₂)ₒ-OH wherein R² is phenyl, pyridyl, H₂N-(CH₂)ₚ-, or C₁-C₆ alkyl, R³ is hydrogen or C₁-C₆ alkyl, o is an integer from 1 to 6, and p is an integer from 1 to 6, (c) hydrogen peroxide, (d) a mineral acid, and (e) water, wherein the polishing composition has a pH from about 1 to about 5.

The wet-process silica can be any suitable wet-process silica. For example, the wet-process silica can be condensation-polymerized silica. Condensation-polymerized silica particles typically are prepared by condensing Si(OH)₄ to form colloidal particles, where colloidal is defined as having an average particle size between about 1 nm and about 1000 nm. Such abrasive particles can be prepared in accordance with U.S. Patent 5,230,833 or can be obtained as any of various commercially available products, such as the Akzo-Nobel Bindzil 50/80, 30/360, 159/500, 40/220, and 40/130 products and the Nalco 1050, 1060, 2327, and 2329 products, as well as other similar products available from DuPont, Bayer, Applied Research, Nissan Chemical, Fuso, and Clariant.

In some embodiments, the wet-process silica comprises substantially spherical particles. In some other embodiments, the wet-process silica comprises particles having an irregular shape.

In certain embodiments, the wet-process silica can be an aluminum-doped wet-process silica. Aluminum-doped wet-process silica particles have trivalent aluminum atoms substituted for a part of the tetravalent silicon atoms on the surface of the particles. An example of a suitable aluminum-doped wet-process silica is the Akzo-Nobel Bindzil 257/360 FG silica. The Bindzil 257/360 FG silica particles also have an irregular shape.

The wet-process silica can have any suitable average particle size (i.e., average particle diameter). The particle size of an abrasive particle is the diameter of the smallest sphere that encompasses the abrasive particle. The wet-process silica can have an average particle size of about 5 nm or more, e.g., about 6 nm or more, about 7 nm or more, about 8 nm or more, about 9 nm or more, about 10 nm or more, about 11 nm or more, about 12 nm or more, about 13 nm or more, about 14 nm or more, or about 15 nm or more. Alternatively, or in addition, the wet-process silica can have an average particle size of about 40 nm or less, e.g., about 38 nm or less, about 36 nm or less, about 34 nm or less, about 32 nm or less, about 30 nm or less, about 28 nm or less, about 26 nm or less, or about 25 nm or less. Thus, the wet-process silica can have an average particle size bounded by any two of the above endpoints recited for the particle size of the wet-process silica. For example, the wet-process silica can have an average particle size of about 5 nm to about 40 nm, about 6 nm to about 40 nm, about 7 nm to about 40 nm, about 8 nm to about 40 nm, about 9 nm to about 40 nm, about 10 nm to about 40 nm, about 10 nm to about 38 nm, about 10 nm to about 36 nm, about 10 nm to about 34 nm, about 10 nm to about 32 nm, about 10 nm to about 30 nm, about 10 nm to about 28 nm, about 10 nm to about 26 nm, about 10 nm to about 25 nm, about 5 nm to about 25 nm, about 5 nm to about 20 nm, about 5 nm to about 15 nm, or about 5 nm to about 10 nm.

The polishing composition can comprise any suitable amount of wet-process silica. Typically, the polishing composition can comprise about 0.2 wt.% or more, e.g., about 0.4 wt.% or more, about 0.6 wt.% or more, about 0.8 wt.% or more, or about 1 wt.% or more, of wet-process silica. Alternatively, or in addition, the polishing composition can contain about 10 wt.% or less, e.g., about 9 wt.% or less, about 8 wt.% or less, about 7 wt.% or less, about 6 wt.% or less, or about 5 wt.% or less, of wet-process silica. Thus, the polishing composition can comprise wet-process silica in amounts bounded by any two of the above endpoints recited for the wet-process silica. For example, the polishing composition can comprise about 0.2 wt.% to about 10 wt.% of wet-process silica, about 0.4 wt.% to about 9 wt.%, about 0.6 wt.% to about 8 wt.%, about 0.8 wt.% to about 7 wt.%, about 1 wt.% to about 6 wt.%, or about 1 wt.% to about 5 wt.% of wet-process silica.

In some embodiments, the polishing composition can comprise two or more different wet-process silicas. The two or more different wet-process silicas can have the same or different average particle sizes, provided that each of the two or more different wet-process silicas has an average particle size as set forth herein.

The wet-process silica comprises abrasive particles which are preferably colloidally stable. The term colloid refers to the suspension of abrasive particles in the liquid carrier. Colloidal stability refers to the maintenance of that suspension through time. In the context of the invention, an abrasive is considered colloidally stable if, when the abrasive is placed into a 100 ml graduated cylinder and allowed to stand unagitated for a time of 2 hours, the difference between the concentration of particles in the bottom 50 ml of the graduated cylinder ([B] in terms of g/ml) and the concentration of particles in the top 50 ml of the graduated cylinder ([T] in terms of g/ml) divided by the initial concentration of particles in the abrasive composition ([C] in terms of g/ml) is less than or equal to 0.5 (i.e., {[B] - [T]}/[C] < 0.5). More preferably, the value of [B]-[T]/[C] is less than or equal to 0.3, and most preferably is less than or equal to 0.1.

The polishing composition comprises a combination of (i) an alcohol of formula (I): R¹-X-(CH₂)ₘ-OH wherein R¹ is phenyl, pyridyl, HO-(CH₂)ₙ-, or C₁-C₆ alkyl, m is an integer from 1 to 6, n is an integer from 1 to 6, and X is absent or is O, and (ii) an alcohol of formula (II): R²-NR³-(CH₂)ₒ-OH wherein R² is phenyl, pyridyl, H₂N-(CH₂)ₚ-, or C₁-C₆ alkyl, R³ is hydrogen or C₁-C₆ alkyl, o is an integer from 1 to 6, and p is an integer from 1 to 6. The C₁-C₆ alkyl group can be straight chain or branched and can be methyl, ethyl, n-propyl, isopropyl, n-butyl, s-butyl, isobutyl, n-heptyl, isoheptyl, n-hexyl, isohexyl, and the like. The alcohol of formula (I) and the alcohol of formula (II) can be any suitable such alcohols. Non-limiting examples of the alcohol of formula (I) include ethylene glycol monomethyl ether, ethylene glycol monoethyl ether, ethylene glycol monopropyl ether, ethylene glycol monoisopropyl ether, ethylene glycol monobutyl ether, ethylene glycol monoisobutyl ether, ethylene glycol mono-s-butyl ether, ethylene glycol monoheptyl ether, ethylene glycol monohexyl ether, benzyl alcohol, 2-phenylethanol, 2-phenoxyethanol, and 2-(2-pyridyl)-ethanol. Non-limiting examples of the alcohol of formula (II) include aminoethylaminoethanol, aminopropylaminoethanol, methylaminoethanol, ethylaminoethanol, propylaminoethanol, butylaminoethanol, heptylaminoethanol, hexylaminoethanol, and 2-(N-ethyl-N-phenylamino)ethanol. In a preferred embodiment, the alcohol of formula (I) is phenoxyethanol (i.e., PhO(CH₂)₂OH) and the alcohol of formula (II) is aminoethylaminoethanol (i.e., H₂N(CH₂)₂NH(CH₂)₂NH₂).

The polishing composition comprises any suitable amount of the alcohol of formula (I). Typically, the polishing composition comprises about 500 ppm or more, e.g., about 750 ppm or more, about 1000 ppm or more, about 1250 ppm or more, about 1500 ppm or more, about 1750 ppm or more, about 2000 ppm or more, about 2250 ppm or more, about 2500 ppm or more, about 2750 ppm or more, about 3000 ppm or more, about 3250 ppm or more, about 3500 ppm or more, about 3750 ppm or more, or about 4000 ppm or more of the alcohol of formula (I). Alternatively, or in addition, the polishing composition comprises about 10,000 ppm or less, e.g., about 9750 ppm or less, about 9500 ppm or less, about 9250 ppm or less, about 9000 ppm or less, about 8750 ppm or less, about 8500 ppm or less, about 8250 ppm or less, about 8000 ppm or less, about 7750 ppm or less, about 7500 ppm or less, about 7250 ppm or less, or about 7000 ppm or less. Thus, the polishing composition can comprise the alcohol of formula (I) in amounts bounded by any two of the above endpoints recited for the alcohol of formula (I). For example, the polishing composition can comprise about 500 ppm to about 10,000 ppm of the alcohol of formula (I), e.g., about 750 ppm to about 10,000 ppm, about 1000 ppm to about 10,000 ppm, about 1000 ppm to about 9500 ppm, about 1000 ppm to about 9000 ppm, about 1500 ppm to about 9000 ppm, about 2000 ppm to about 9000 ppm, about 2000 ppm to about 8500 ppm, about 2000 ppm to about 8000 ppm, about 2000 ppm to about 7500 ppm, about 2000 ppm to about 7000 ppm, about 2500 ppm to about 7000 ppm, about 3000 ppm to about 7000 ppm, about 3500 ppm to about 7000 ppm, about 4000 ppm to about 7000 ppm, about 4500 ppm to about 7000 ppm, about 5000 ppm to about 7000 ppm, about 5000 ppm to about 7500 ppm, about 5000 ppm to about 8000 ppm, about 5000 ppm to about 8500 ppm, or about 5000 ppm to about 9000 ppm of the alcohol of formula (I).

The polishing composition comprises any suitable amount of the alcohol of formula (II). Typically, the polishing composition comprises about 50 ppm or more, e.g., about 75 ppm or more, about 100 ppm or more, about 125 ppm or more, about 150 ppm or more, about 175 ppm or more, about 200 ppm or more, about 225 ppm or more, about 250 ppm or more, about 275 ppm or more, or about 300 ppm or more of the alcohol of formula (II). Alternatively, or in addition, the polishing composition comprises about 1000 ppm or less of the alcohol of formula (II), e.g., about 975 ppm or less, about 950 ppm or less, about 925 ppm or less, about 900 ppm or less, about 875 ppm or less, about 850 ppm or less, about 825 ppm or less, about 800 ppm or less, about 775 ppm or less, about 750 ppm or less, about 725 ppm or less, or about 700 ppm or less. Thus, the polishing composition can comprise the alcohol of formula (II) in amounts bounded by any two of the above endpoints recited for the alcohol of formula (II). For example, the polishing composition can comprise about 50 ppm to about 1000 ppm of the alcohol of formula (II), e.g., about 75 ppm to about 1000 ppm, about 100 ppm to about 1000 ppm, about 100 ppm to about 950 ppm, about 100 ppm to about 900 ppm, about 150 ppm to about 900 ppm, about 200 ppm to about 900 ppm, about 200 ppm to about 850 ppm, about 200 ppm to about 800 ppm, about 200 ppm to about 750 ppm, about 200 ppm to about 700 ppm, about 250 ppm to about 700 ppm, or about 300 ppm to about 700 ppm of the alcohol of formula (I).

In certain embodiments, the polishing composition comprises an alcohol of formula (III): R¹-O-(CH₂)ₘ-OH wherein R¹ is phenyl, pyridyl, HO-(CH₂)ₙ-, or C₁-C₆ alkyl, m is an integer from 1 to 6, and n is an integer from 1 to 6. The C₁-C₆ alkyl group can be straight chain or branched and can be methyl, ethyl, n-propyl, isopropyl, n-butyl, s-butyl, isobutyl, n-heptyl, isoheptyl, n-hexyl, isohexyl, and the like. The alcohol of formula (III) can be any suitable such alcohol. Non-limiting examples of the alcohol of formula (III) include ethylene glycol monomethyl ether, ethylene glycol monoethyl ether, ethylene glycol monopropyl ether, ethylene glycol monoisopropyl ether, ethylene glycol monobutyl ether, ethylene glycol monoisobutyl ether, ethylene glycol mono-s-butyl ether, ethylene glycol monoheptyl ether, ethylene glycol monohexyl ether, and 2-phenoxyethanol. In a preferred embodiment, the alcohol of formula (III) is phenoxyethanol (i.e., PhO(CH₂)₂OH).

The polishing composition comprises any suitable amount of the alcohol of formula (III). Typically, the polishing composition comprises about 500 ppm or more, e.g., about 750 ppm or more, about 1000 ppm or more, about 1250 ppm or more, about 1500 ppm or more, about 1750 ppm or more, about 2000 ppm or more, about 2250 ppm or more, about 2500 ppm or more, about 2750 ppm or more, about 3000 ppm or more, about 3250 ppm or more, about 3500 ppm or more, about 3750 ppm or more, or about 4000 ppm or more of the alcohol of formula (III). Alternatively, or in addition, the polishing composition comprises about 10,000 ppm or less, e.g., about 9750 ppm or less, about 9500 ppm or less, about 9250 ppm or less, about 9000 ppm or less, about 8750 ppm or less, about 8500 ppm or less, about 8250 ppm or less, about 8000 ppm or less, about 7750 ppm or less, about 7500 ppm or less, about 7250 ppm or less, or about 7000 ppm or less of the alcohol of formula (III). Thus, the polishing composition can comprise the alcohol of formula (III) in amounts bounded by any two of the above endpoints recited for the alcohol of formula (III). For example, the polishing composition can comprise about 500 ppm to about 10,000 ppm of the alcohol of formula (III), e.g., about 750 ppm to about 10,000 ppm, about 1000 ppm to about 10,000 ppm, about 1000 ppm to about 9500 ppm, about 1000 ppm to about 9000 ppm, about 1500 ppm to about 9000 ppm, about 2000 ppm to about 9000 ppm, about 2000 ppm to about 8500 ppm, about 2000 ppm to about 8000 ppm, about 2000 ppm to about 7500 ppm, about 2000 ppm to about 7000 ppm, about 2500 ppm to about 7000 ppm, about 3000 ppm to about 7000 ppm, about 3500 ppm to about 7000 ppm, about 4000 ppm to about 7000 ppm, about 4500 ppm to about 7000 ppm, about 5000 ppm to about 7000 ppm, about 5000 ppm to about 7500 ppm, about 5000 ppm to about 8000 ppm, about 5000 ppm to about 8500 ppm, or about 5000 ppm to about 9000 ppm of the alcohol of formula (III).

The polishing composition can have any suitable pH. Typically, the polishing composition can have a pH of about 1 or more, e.g., about 1.2 or more, about 1.4 or more, about 1.6 or more, about 1.8 or more, or about 2 or more. Alternatively, or in addition, the polishing composition can have a pH of about 5 or less, e.g., about 4.5 or less, about 4 or less, about 3.5 or less, or about 3 or less. Thus, the polishing composition can have a pH bounded by any two of the above endpoints recited for the pH of the polishing composition. For example, the polishing composition can have a pH of about 1 to about 5, e.g., about 1 to about 4.5, about 1 to about 4, about 1 to about 3.5, about 1 to about 3, about 1 to about 2.5, or about 1 to about 2.

The polishing composition comprises hydrogen peroxide. The hydrogen peroxide can be present in any suitable amount in the polishing composition. For example, the polishing composition can comprise from about 0.1 wt.% to about 10 wt.% of hydrogen peroxide, e.g., about 0.5 wt.% to about 10 wt.%, about 0.5 wt.% to about 5 wt.%, about 0.1 wt.% to about 5 wt.%, about 0.1 wt.% to about 2.5 wt.%, or about 0.1 wt.% to about 1 wt.% of hydrogen peroxide.

The polishing composition comprises a mineral acid. Non-limiting examples of suitable mineral acids include nitric acid, sulfuric acid, and phosphoric acid.

The polishing composition comprises water. The water can be any suitable water and can be, for example, deionized water or distilled water. In some embodiments, the polishing composition can further comprise one or more organic solvents in combination with the water. For example, the polishing composition can further comprise a hydroxylic solvent such as methanol or ethanol, a ketonic solvent, an amide solvent, a sulfoxide solvent, and the like. Preferably, the polishing composition comprises pure water.

The polishing composition can further comprise a base to adjust the pH of the polishing composition. Non-limiting examples of suitable bases include sodium hydroxide, potassium hydroxide, and ammonium hydroxide.

In certain embodiments, the polishing composition is free or substantially free of a water-soluble polymer, particularly a water-soluble polymer having a molecular weight of 500 or more. Examples of water-soluble polymers having a molecular weight of 500 or more that can be excluded from the polishing composition include polysaccharides such as alginic acid, pectin acid, carboxymethylcellulose, agar, curdlan, pullulan; polycarboxylic acids, the esters and salts thereof such as polyaspartic acid, polyglutamic acid, polylysine, polymalic acid, polymethacrylic acid, ammonium polymethacrylate salt, sodium polymethacrylate salt, polyamide acid, polymaleic acid, polyitaconic acid, polyfumaric acid, poly(p-styrenecarboxylic acid), polyacrylic acid, polyacrylamide, aminopolyacrylamide, ammonium polyacrylate salt, sodium polyacrylate salt, polyamide acid, polyamide acid ammonium salt, polyamide acid sodium salt and polyglyoxylic acid; vinyl polymers such as polyvinylalcohol, polyvinylpyrrolidone and polyacrolein, and the like.

In certain embodiments, the polishing composition is free or substantially free of a heterocyclic aromatic compound. Examples of water-soluble polymers having a molecular weight of 500 or more that can be excluded from the polishing composition include pyrazine, triazines, oxadiazoles, thiadiazoles, aminopyrazoles, pyrazoles, aminoimidazoles, methylimidazoles, ethylimidazoles, imidazoles, benzimidazoles, triazoles, aminotriazoles, mercaptotriazoles, tetrazoles, aminotetrazole, 1H-benzotriazole, 1H-tolyltriazole, aminobenzotrizoles, and alkyl- or amino-substituted derivatives thereof.

The polishing composition can be prepared by any suitable technique, many of which are known to those skilled in the art. The polishing composition can be prepared in a batch or continuous process. Generally, the polishing composition can be prepared by combining the components thereof in any order. The term "component" as used herein includes individual ingredients (e.g., wet-process silica, alcohol of formula (I), alcohol of formula (II), alcohol of formula (III), hydrogen peroxide, mineral acid, etc.) as well as any combination of ingredients (e.g., wet-process silica, alcohol of formula (I), alcohol of formula (II), alcohol of formula (III), hydrogen peroxide, mineral acid, etc.).

For example, the wet-process silica can be dispersed in water. The alcohol of formula (I) and/or alcohol of formula (II) or alcohol of formula (III), and mineral acid can then be added, and mixed by any method that is capable of incorporating the components into the polishing composition. The hydrogen peroxide can be added at any time during the preparation of the polishing composition. The polishing composition can be prepared prior to use, with one or more components, such as the hydrogen peroxide, added to the polishing composition just before use (e.g., within about 1 minute before use, or within about 1 hour before use, or within about 7 days before use). The polishing composition also can be prepared by mixing the components at the surface of the substrate during the polishing operation.

The polishing composition can be supplied as a one-package system comprising wet-process silica, alcohol of formula (I) and/or alcohol of formula (II) or alcohol of formula (III), mineral acid, and water. Alternatively, the wet-process silica can be supplied as a dispersion in water in a first container, and alcohol of formula (I) and/or alcohol of formula (II) or alcohol of formula (III), and mineral acid can be supplied in a second container, either in dry form, or as a solution or dispersion in water. The hydrogen peroxide desirably is supplied separately from the other components of the polishing composition and is combined, e.g., by the end-user, with the other components of the polishing composition shortly before use (e.g., 1 week or less prior to use, 1 day or less prior to use, 1 hour or less prior to use, 10 minutes or less prior to use, or 1 minute or less prior to use). The components in the first or second container can be in dry form while the components in the other container can be in the form of an aqueous dispersion. Moreover, it is suitable for the components in the first and second containers to have different pH values, or alternatively to have substantially similar, or even equal, pH values. Other two-container, or three or more-container, combinations of the components of the polishing composition are within the knowledge of one of ordinary skill in the art.

The polishing composition of the invention also can be provided as a concentrate which is intended to be diluted with an appropriate amount of water prior to use. In such an embodiment, the polishing composition concentrate can comprise the wet-process silica, alcohol of formula (I), alcohol of formula (II) and/or mineral acid or alcohol of formula (III), and water, with or without the hydrogen peroxide, in amounts such that, upon dilution of the concentrate with an appropriate amount of water, and the hydrogen peroxide if not already present in an appropriate amount, each component of the polishing composition will be present in the polishing composition in an amount within the appropriate range recited above for each component. For example, the wet-process silica, alcohol of formula (I) and/or alcohol of formula (II) or alcohol of formula (III), and mineral acid can each be present in the concentration in an amount that is about 2 times (e.g., about 3 times, about 4 times, or about 5 times) greater than the concentration recited above for each component so that, when the concentrate is diluted with an equal volume of (e.g., 2 equal volumes of water, 3 equal volumes of water, or 4 equal volumes of water, respectively), along with the hydrogen peroxide in a suitable amount, each component will be present in the polishing composition in an amount within the ranges set forth above for each component. Furthermore, as will be understood by those of ordinary skill in the art, the concentrate can contain an appropriate fraction of the water present in the final polishing composition in order to ensure that other components are at least partially or fully dissolved in the concentrate.

The invention also provides a method of chemically mechanically polishing a substrate comprising (i) providing a substrate, (ii) providing a polishing pad, (iii) providing a chemical-mechanical polishing composition comprising (a) wet-process silica, (b) a combination of (i) an alcohol of formula (I): R¹-X-(CH₂)ₘ-OH wherein R¹ is phenyl, pyridyl, HO-(CH₂)ₙ-, or C₁-C₆ alkyl, m is an integer from 1 to 6, n is an integer from 1 to 6, and X is absent or is O, and (ii) an alcohol of formula (II): R²-NR³-(CH₂)ₒ-OH wherein R² is phenyl, pyridyl, H₂N-(CH₂)ₚ-, or C₁-C₆ alkyl, R³ is hydrogen or C₁-C₆ alkyl, o is an integer from 1 to 6, and p is an integer from 1 to 6, (c) hydrogen peroxide, (d) a mineral acid, and (e) water, wherein the polishing composition has a pH from about 1 to about 5, (iv) contacting the substrate with the polishing pad and the chemical-mechanical polishing composition, and (v) moving the polishing pad and the chemical mechanical polishing composition relative to the substrate to abrade at least a portion of the substrate to polish the substrate.

In other embodiments, the invention provides a method of chemically mechanically polishing a substrate comprising (i) providing a substrate, (ii) providing a polishing pad, (iii) providing a chemical-mechanical polishing composition comprising (a) wet-process silica, phenoxyethanol, ethylene glycol monobutyl ether, or benzyl alcohol, (c) hydrogen peroxide, (d) a mineral acid, and (e) water, wherein the polishing composition has a pH from about 1 to about 5, (iv) contacting the substrate with the polishing pad and the chemical-mechanical polishing composition, and (v) moving the polishing pad and the chemical mechanical polishing composition relative to the substrate to abrade at least a portion of the substrate to polish the substrate.

The substrate to be polished using the method of the invention can be any suitable substrate, especially a substrate that contains nickel-phosphorous. A preferred substrate comprises at least one layer, especially an exposed layer for polishing, comprising, consisting essentially of, or consisting of nickel-phosphorous, such that at least a portion of the nickel-phosphorous is abraded (i.e., removed) to polish the substrate. Particularly suitable substrates include, but are not limited to, memory or rigid disks, such as aluminum disks coated with nickel-phosphorous.

The polishing method of the invention is particularly suited for use in conjunction with a chemical-mechanical polishing (CMP) apparatus. Typically, the apparatus comprises a platen, which, when in use, is in motion and has a velocity that results from orbital, linear, or circular motion, a polishing pad in contact with the platen and moving with the platen when in motion, and a carrier that holds a substrate to be polished by contacting and moving relative to the surface of the polishing pad. The polishing of the substrate takes place by the substrate being placed in contact with the polishing pad and the polishing composition of the invention and then the polishing pad moving relative to the substrate, so as to abrade at least a portion of the substrate to polish the substrate.

A substrate can be planarized or polished with the chemical-mechanical polishing composition with any suitable polishing pad (e.g., polishing surface). Suitable polishing pads include, for example, woven and non-woven polishing pads. Moreover, suitable polishing pads can comprise any suitable polymer of varying density, hardness, thickness, compressibility, ability to rebound upon compression, and compression modulus. Suitable polymers include, for example, polyvinylchloride, polyvinylfluoride, nylon, fluorocarbon, polycarbonate, polyester, polyacrylate, polyether, polyethylene, polyamide, polyurethane, polystyrene, polypropylene, coformed products thereof, and mixtures thereof.

Desirably, the CMP apparatus further comprises an *in situ* polishing endpoint detection system, many of which are known in the art. Techniques for inspecting and monitoring the polishing process by analyzing light or other radiation reflected from a surface of the workpiece are known in the art. Such methods are described, for example, in U.S. Patent 5,196,353, U.S. Patent 5,433,651, U.S. Patent 5,609,511, U.S. Patent 5,643,046, U.S. Patent 5,658,183, U.S. Patent 5,730,642, U.S. Patent 5,838,447, U.S. Patent 5,872,633, U.S. Patent 5,893,796, U.S. Patent 5,949,927, and U.S. Patent 5,964,643. Desirably, the inspection or monitoring of the progress of the polishing process with respect to a workpiece being polished enables the determination of the polishing end-point, i.e., the determination of when to terminate the polishing process with respect to a particular workpiece.

Desirably, the inventive polishing composition exhibits significantly reduced scratching of substrate surfaces and increased removal rates for nickel-phosphorous when used to polish substrates coated with nickel-phosphorous. Polishing compositions comprising wet-process silica and the alcohol of formula (I) and/or the alcohol of formula (III) exhibit significantly reduced substrate scratching and also an increased nickel-phosphorous removal rate compared to polishing compositions not containing the alcohol of formula (I) and/or the alcohol of formula (III). Polishing compositions comprising wet-process silica and the alcohol of formula (II) exhibit significantly reduced substrate scratching and a somewhat reduced nickel-phosphorous removal rate compared to polishing compositions not containing the alcohol of formula (II). Polishing compositions comprising wet-process silica and a combination of the alcohol of formula (I) and/or the alcohol of formula (III) and the alcohol of formula (II) exhibit significantly reduced substrate scratching compared to polishing compositions comprising only one of the alcohol of formula (I) and/or the alcohol of formula (III) or the alcohol of formula (II) and to polishing compositions not containing either of the alcohol of formula (I) and/or the alcohol of formula (III) or the alcohol of formula (II). In certain embodiments, polishing compositions comprising wet-process silica and a combination of the alcohol of formula (I) and/or the alcohol of formula (III) and the alcohol of formula (II) exhibit an increased nickel-phosphorous removal rate compared with polishing compositions not containing any of the alcohols of formula (I), (II), or (III).

Furthermore, the nickel-phosphorous removal rate can be influenced by the selection of wet-process silica. Polishing compositions comprising wet-process silica particles that are relatively mechanically stronger by virtue of having an irregular particle shape and/or or a particle diameter such as > 12 nm in separate combination with an alcohol of formula (I) or formula (III) or in combination with both an alcohol of formula (I) and an alcohol of formula (II) exhibit increased nickel-phosphorous removal rates relative to polishing compositions not containing the alcohols. Polishing compositions comprising wet-process silica particles having an irregular particle shape and/or or a particle diameter such as > 12 nm in combination with an alcohol of formula (II) alone exhibit improvement in total scratch count and the same or slightly lower nickel-phosphorous removal rate. Polishing compositions comprising wet-process silica particles that are relatively mechanically weaker by virtue of having a substantially spherical particle shape in combination with both an alcohol of formula (I) and an alcohol of formula (II) exhibit improvement in total scratch count and the same or slightly lower nickel-phosphorous removal rate.

### EXAMPLES

The following examples further illustrate the invention but, of course, should not be construed as in any way limiting its scope.

In the examples that follow, nickel-phosphorous-coated aluminum disks were polished with an FK1N polishing pad (Fujibo Group, Tokyo, Japan) using a Hamai 9B polisher (Hamai Co., Ltd, Tokyo Japan) with a polishing composition flow rate of 300 mL/min, a downforce of 110 g/cm², an upper platen speed of about 1 rpm, and a lower platen speed of about 32 rpm. After polishing, the post-polished disks were clean and dried with a cleaner commercially available as Invenpro^{™} ISW001 (Invenpro, Selangor Darul Ehsan, Malaysia). Weight measurements of post-polished disks were performed to determine removal rate. Total scratch count was determined using a Candela^{™} 7100 wafer surface defect inspection system (KLA Tencor, Milpitas, CA).

### EXAMPLE 1

This example demonstrates the nickel-phosphorous removal rate and total scratch count exhibited by polishing compositions comprising wet-process silica and an alcohol of formula (I) when used to polish substrates comprising nickel-phosphorous-coated aluminum disks.

Polishing Compositions 1A-1J each contained 5 wt.% of a wet-process silica having an average particle size of 7 nm and having an irregular particle shape and 0.6 wt.% hydrogen peroxide in water at a pH of 1.6, where the pH was adjusted with H₃PO₄. Polishing Composition 1A did not contain any additional components. Polishing Compositions 1B-1D further contained 0.05 wt.%, 0.2 wt.%, and 1 wt.%, respectively, ethylene glycol butyl ether. Polishing Compositions 1E-1G further contained 0.05 wt.%, 0.2 wt.%, and 0.5 wt.%, respectively, benzyl alcohol. Polishing Compositions 1H-1J further contained 0.05 wt.%, 0.2 wt.%, and 0.5 wt.%, respectively, 2-phenoxyethanol. Ethylene glycol butyl ether, benzyl alcohol, and 2-phenoxyethanol are alcohols of formula (I).

Following polishing, the nickel-phosphorous removal rate and total scratch counts were determined. The results are set forth in Table 1.

**Table 1: Effect of an Alcohol of Formula (I) on Removal Rate and Total Scratch Count**

| Polishing Composition | Alcohol of Formula (I) | Amount of Alcohol of Formula (I) (wt.%) | Removal Rate (mg/min) | Total Scratches (Counts/Disk Side) |
|---|---|---|---|---|
| 1A (control) | - | 0 | 5.15 | 366 |
| 1B | Ethylene Glycol Butyl Ether | 0.05 | 5.14 | 330 |
| 1C | Ethylene Glycol Butyl Ether | 0.2 | 4.85 | 382 |
| 1D | Ethylene Glycol Butyl Ether | 1 | 5.63 | 181 |
| 1E | Benzyl Alcohol | 0.05 | 5.25 | 416 |
| 1F | Benzyl Alcohol | 0.2 | 5.35 | 307 |
| 1G | Benzyl Alcohol | .05 | 5.85 | 113 |
| 1H | 2- Phenoxy ethanol | 0.05 | 5.71 | 230 |
| 1I | 2- Phenoxy ethanol | 0.2 | 5.04 | 160 |
| 1J | 2-Phenoxy ethanol | 0.5 | 6.43 | 69 |

As is apparent from the results set forth in Table 1, Polishing Compositions 1D, 1G, and 1J, which contained 1 wt.%, 0.5 wt.%, and 0.5 wt.%, respectively, of an alcohol of formula (I), exhibited nickel-phosphorous removal rates that were approximately 109%, 114%, and 125%, respectively, of the nickel-phosphorous removal rate exhibited by Polishing Composition 1A, which did not contain an alcohol of formula (I). The use of Polishing Compositions 1D, 1G, and 1J resulted in total scratch counts that were approximately 40%, 31%, and 19%, respectively, of the total scratch count resulting from polishing with Polishing Composition 1A. These results demonstrate the desirable combination of an improved removal rate and reduced scratch count provided by the use of an alcohol of formula (I) in a polishing composition for nickel-phosphorous.

### EXAMPLE 2

This example demonstrates the nickel-phosphorous removal rate and total scratch count exhibited by polishing compositions comprising wet-process silica and an alcohol of formula (I) alone, an alcohol of formula (II) alone, and a combination of an alcohol of formula (I) and an alcohol of formula (II) when used to polish substrates comprising nickel-phosphorous-coated aluminum disks.

Polishing Compositions 2A-2H each contained 5 wt.% of a wet-process silica and 0.6 wt.% hydrogen peroxide in water at a pH of 1.6, where the pH was adjusted with H₃PO₄. Polishing Compositions 2A-2D contained wet-process silica having a particle size of 7 nm and having an irregular particle shape. Polishing Compositions 2E-2H contained 2.5 wt.% wet-process silica having an average particle size of 7 nm and 2.5 wt.% of wet-process silica having an average particle size of 5 nm, with both of the wet-process silicas having a substantially spherical particle shape. Polishing Compositions 2A and 2E (control) did not did not contain any additional components. Polishing Compositions 2B and 2F further contained 0.03 wt.% of aminoethylaminoethanol (AEEA) (i.e., an alcohol of formula (II)). Polishing Compositions 2C and 2G further contained 0.03 wt.% of 2-phenoxethanol (POE) (i.e., an alcohol of formula (I)). Polishing Compositions 2D and 2H further contained 0.03 wt.% of aminoethylaminoethanol and 0.5 wt.% of 2-phenoxyethanol.

Following polishing, the nickel-phosphorous removal rate and total scratch counts were determined. The results are set forth in Table 2.

**Table 2: Effect of an Alcohol of Formula (I), an Alcohol of Formula (II), and a Combination Thereof on Removal Rate and Total Scratch Count**

| Polishing Composition | Silica | Alcohol | Removal Rate (mg/min) | Total Scratches (Counts/Disk Side) |
|---|---|---|---|---|
| 2A | 5.0 wt.% particle size 7 nm (irregular particle shape) | - | 6.78 | 410 |
| 2B | | AEEA | 6.32 | 236 |
| 2C | | POE | 10.09 | 158 |
| 2D | | AEEA + POE | 8.03 | 71 |
| 2E | 2.5 wt.% particle size 7 nm and 2.5 wt.% particle size 5 nm (spherical particles) | - | 4.60 | 238 |
| 2F | | AEEA | 2.98 | 196 |
| 2G | | POE | 5.64 | 145 |
| 2H | | AEEA + POE | 3.48 | 58 |

As is apparent from the results set forth in Table 2, Polishing Composition 2B, which contained wet-process silica having an average particle size of 7 nm and having an irregular particle shape and 0.03 wt.% AEEA, exhibited a nickel-phosphorous removal rate that was approximately 93% and 65% the removal rate exhibited by Polishing Composition 2A, which did not contain AEEA. Polishing Composition 2F, which contained a combination of substantially spherical wet-process silica having an average particle size of 7 nm and substantially spherical wet-process silica having an average particle size of 5 nm and 0.03 wt.% AEEA, exhibited a nickel-phosphorous removal rate that was approximately 65% the removal rate exhibited by Polishing Composition 2E, which did not contain AEEA. The higher nickel-phosphorous removal rate exhibited by Polishing Composition 2B compared to Polishing Composition 2F is attributed to the higher mechanical strength of the irregularly shaped wet-process silica present in Polishing Composition 2B compared to the substantially spherical shaped wet-process silica present in Polishing Composition 2F. Polishing Compositions 2B and 2F exhibited total scratch counts that were 58% and 82%, respectively, of the total scratch count exhibited by Polishing Compositions 2A and 2E, respectively.

Polishing Composition 2C, which contained wet-process silica having an average particle size of 7 nm and having an irregular particle shape and 0.5 wt.% POE, and Polishing Composition 2G, which contained a combination of substantially spherical wet-process silica having an average particle size of 7 nm and substantially spherical wet-process silica having an average particle size of 5 nm and 0.5 wt.% POE, exhibited nickel-phosphorous removal rates that were approximately 149% and 123%, respectively, the removal rate exhibited by Polishing Compositions 2A and 2E, which did not contain POE. Polishing Compositions 2C and 2G exhibited total scratch counts that were 39% and 61%, respectively, of the total scratch count exhibited by Polishing Compositions 2A and 2E, respectively.

Polishing Composition 2D, which contained wet-process silica having an average particle size of 7 nm and having an irregular particle shape, 0.03 wt.% AEEA and 0.5 wt.% POE, and Polishing Composition 2H, which contained a combination of substantially spherical wet-process silica having an average particle size of 7 nm and substantially spherical wet-process silica having an average particle size of 5 nm, 0.03 wt.% AEEA, and 0.5 wt.% POE, exhibited nickel-phosphorous removal rates that were approximately 118% and 76%, respectively, the removal rate exhibited by Polishing Compositions 2A and 2E, which did not contain POE or AEEA. Polishing Compositions 2D and 2H exhibited total scratch counts that were 17% and 24%, respectively, of the total scratch count exhibited by Polishing Compositions 2A and 2E, respectively.

Thus, Polishing Compositions 2D and 2H, containing a combination of an alcohol of formula (I) and an alcohol of formula (II), exhibited the lowest total scratch count of all of the polishing compositions while maintaining useful nickel-phosphorous removal rates.

In addition, Polishing Compositions 2C and 2D, which contained wet-process silica having an average particle size of 7 nm and having an irregular particle shape and further contained POE or a combination of POE and AEEA, exhibited nickel-phosphorous removal rates that were approximately 148% and 118%, respectively, the nickel-phosphorous removal rate exhibited by the control polishing composition, which did not contain POE or AEEA. Polishing Compositions 2G and 2H, which contained a combination of substantially spherical wet-process silica having an average particle size of 7 nm and substantially spherical wet-process silica having an average particle size of 5 nm and further contained POE or a combination of POE and AEEA, exhibited nickel-phosphorous removal rates that were approximately 122% and 77%, respectively, the nickel-phosphorous removal rate exhibited by the control polishing composition, which did not contain POE or AEEA. The difference in nickel-phosphorous removal rates between Polishing Compositions 2C and 2D and Polishing Compositions 2G and 2H is attributed to the relatively mechanically harder wet-process silica particles in Polishing Compositions 2C and 2D compared to Polishing Compositions 2G and 2H. However, the total scratch counts exhibited by Polishing Compositions 2D and 2H was comparable.

### EXAMPLE 3

This example demonstrates the nickel-phosphorous removal rate and total scratch count exhibited by polishing compositions comprising wet-process silica of various average particle sizes and a combination of an alcohol of formula (I) and an alcohol of formula (II) when used to polish substrates comprising nickel-phosphorous-coated aluminum disks.

Polishing Compositions 3A-3J each contained 5 wt.% of a wet-process silica and 0.6 wt.% of hydrogen peroxide in water at a pH of 1.6, with the pH being adjusted with H₃PO₄. Each pair of Polishing Compositions 3A and 3B, 3C and 3D, 3E and 3F, 3G and 3H, and 3I and 3J contained the same type of wet-process silica, as listed in Table 3. Polishing Compositions 3A, 3C, 3E, 3G, and 3I did not contain any additional components. Polishing Compositions 3B, 3D, 3F, 3H, and 3J each further contained a combination of 0.03 wt.% aminoethylaminoethanol (AEEA) (i.e., an alcohol of formula (II)) and 0.5 wt.% of 2-phenoxyethanol (POE) (i.e., an alcohol of formula (I)).

Following polishing, the nickel-phosphorous removal rate and total scratch counts were determined. The results are set forth in Table 3.

**Table 3: Effect of a Combination of an Alcohol of Formula (I) and an Alcohol of Formula (II) on Removal Rate and Total Scratch Count**

| Polishing Composition | Wet-Process Silica | Average Particle Size of Wet-Process Silica (nm) | Additives | Removal Rate (mg/min) | Total Scratch Count |
|---|---|---|---|---|---|
| 3A (comparative) | 5.0 wt.% irregular particle shape | 7 | - | 4.91 | 539 |
| 3B (inventive) | | | AEEA + POE | 8.20 | 206 |
| 3C (comparative) | 5 wt.% spherical particles | 7 | - | 4.49 | 345 |
| 3D (inventive) | | | AEEA + POE | 3.48 | 45 |
| 3E (comparative) | 2.5 wt.% particle size 7 nm and 2.5 wt.% particle size 5 nm (spherical particles) | 7 and 5 | - | 3.71 | 173 |
| 3F (inventive) | | | AEEA + POE | 3.36 | 41 |
| 3G (comparative) | 5 wt.% spherical particles | 12 | - | 5.38 | 610 |
| 3H (inventive) | | | AEEA + POE | 5.75 | 66 |
| 3I (comparative) | 5 wt.% spherical particles | 22 | - | 5.83 | 24307 |
| 3J (inventive) | | | AEEA + POE | 6.87 | 400 |

As is apparent from the results set forth in Table 3, all of inventive Polishing Compositions 3B, 3D, 3F, 3H, and 3J exhibited a total scratch count that ranged between 1.6% and 38% of the total scratch count exhibited by comparative Polishing Compositions 3A, 3C, 3E, 3G, and 3I. More specifically, Polishing Composition 3J, which contained substantially spherical wet-process silica having an average particle size of 22 nm and further contained AEEA and POE, exhibited a total scratch count that was approximately 1.6% of the total scratch count exhibited by comparative Polishing Composition 3I, which did not contain AEEA and POE.

The presence of AEEA and POE resulted in only minor changes in the removal rate, with the exception of Polishing Composition 3B, which contained wet-process silica having an average particle size of 7 nm and having an irregular particle shape, and further contained AEEA and POE, which exhibited a nickel-phosphorous removal rate that was approximately 166% the nickel-phosphorous removal rate exhibited by comparative Polishing Composition 3A, which did not contain AEEA and POE. These results demonstrate that the combination of an alcohol of formula (I) and an alcohol of formula (II) desirably maintains a useful Ni-P removal rate, or improves the Ni-P removal rate while significantly reducing the total scratch count that results from polishing with polishing compositions comprising wet-process silica. These results further demonstrate that polishing compositions comprising wet-process silica having an irregular particle shape in combination with an alcohol of formula (I) and an alcohol of formula (II) exhibit an increased nickel-phosphorous removal rate as compared to polishing compositions comprising substantially spherical wet-process silica.

### EXAMPLE 4

This example demonstrates the effect of aminoethylaminoethanol (AEEA) and 2-phenoxyethanol (POE) concentration on the removal rate and total scratch count exhibited by a polishing composition comprising wet-process silica, hydrogen peroxide, and a combination of AEEA and POE.

Substrates comprising nickel-phosphorous-coated memory disks were polished with Polishing Compositions 4A-4I comprising 5.0 wt.% substantially spherical wet-process silica (Nalco 1030C), 0.6 wt.% of hydrogen peroxide, and various concentrations of AEEA and POE as listed in Table 4, in water at a pH of 1.6, where the pH was adjusted with H₃PO₄. The POE concentration was 0.3 wt.%, 0.5 wt.%, and 0.7 wt.% at three AEEA concentrations of 0.03 wt.%, 0.05 wt.%, and 0.07 wt.%.

Following polishing, the removal rate and total scratch count was determined for each of the substrates, and the results set forth in Table 4.

**Table 4: Effect of Alcohol Concentration on Ni-P Removal Rate and Scratch Count**

| Polishing Composition | AEEA (wt.%) | POE (wt.%) | Removal Rate (mg/min) | Total Scratch Count |
|---|---|---|---|---|
| 4A (invention) | 0.03 | 0.3 | 7.23 | 121 |
| 4B (invention) | | 0.5 | 7.57 | 78 |
| 4C (invention) | | 0.7 | 9.68 | 41 |
| 4D (invention) | 0.05 | 0.3 | 6.56 | 99 |
| 4E (invention) | | 0.5 | 8.00 | 47 |
| 4F (invention) | | 0.7 | 8.75 | 38 |
| 4G (invention) | 0.07 | 0.3 | 7.30 | 59 |
| 4H (invention) | | 0.5 | 7.94 | 124 |
| 4I (invention) | | 0.7 | 9.04 | 38 |

As is apparent from the results set forth in Table 4, the nickel-phosphorous removal rate increased with an increase in the POE concentration at all three concentrations of AEEA, with the AEEA concentration showing little effect on the nickel-phosphorous removal rate (compare, for example, the Ni-P removal rates of Polishing Compositions 4A, 4D, and 4G; 4B, 4E, and 4H; and 4C, 4F, and 4I).

The total scratch count at the lowest POE concentration of 0.3 wt.% decreased with an increase in the AEEA concentration from 0.03 wt.% to 0.07 wt.% (compare, for example, the total scratch counts exhibited by Polishing Compositions 4A, 4D, and 4G). The total scratch count at the highest POE concentrations was not significantly affected by the AEEA concentration (compare, for example, the total scratch counts exhibited by Polishing Compositions 4C, 4F, and 4I). At a given AEEA concentration, the total scratch count decreased with increasing concentration of POE (compare, for example, the total scratch counts exhibited by Polishing Compositions 4A-4C, 4D-4F, and 4G-4I).

The use of the terms "a" and "an" and "the" and "at least one" and similar referents in the context of describing the invention (especially in the context of the following claims) are to be construed to cover both the singular and the plural, unless otherwise indicated herein or clearly contradicted by context. The use of the term "at least one" followed by a list of one or more items (for example, "at least one of A and B") is to be construed to mean one item selected from the listed items (A or B) or any combination of two or more of the listed items (A and B), unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description.

## Claims

1. A chemical-mechanical polishing composition comprising:
(a) wet-process silica,
(b) a combination of
(i) an alcohol of formula (I): R¹-X-(CH₂)ₘ-OH wherein
R¹ is phenyl, pyridyl, HO-(CH₂)ₙ-, or C₁-C₆ alkyl,
m is an integer from 1 to 6,
n is an integer from 1 to 6, and
X is absent or is O, and
(ii) an alcohol of formula (II): R²-NR³-(CH₂)ₒ-OH wherein
R² is phenyl, pyridyl, H₂N-(CH₂)ₚ-, or C₁-C₆ alkyl,
R³ is hydrogen or C₁-C₆ alkyl,
o is an integer from 1 to 6, and
p is an integer from 1 to 6,
(c) hydrogen peroxide,
(d) a mineral acid, and
(e) water,
wherein the polishing composition has a pH from 1 to 5.

2. The polishing composition of claim 1, wherein the wet-process silica has a particle size of 5 nm to 25 nm.

3. The polishing composition of claim 2, wherein the wet-process silica has a particle size of 5 nm to 10 nm.

4. The polishing composition of claim 1, wherein the alcohol of formula (I) is phenoxyethanol, ethylene glycol monobutyl ether, or benzyl alcohol.

5. The polishing composition of claim 4, wherein the alcohol of formula (I) is phenoxyethanol.

6. The polishing composition of claim 1, wherein the alcohol of formula (II) is aminoethylaminoethanol.

7. The polishing composition of claim 1, wherein the polishing composition comprises 1000 ppm to 10,000 ppm of the alcohol of formula (I) and100 ppm to 1000 ppm of the alcohol of formula (II).

8. The polishing composition of claim 1, wherein the polishing composition has a pH of 1 to 2.

9. A method of chemically mechanically polishing a substrate comprising:
(i) providing a substrate,
(ii) providing a polishing pad,
(iii) providing a chemical-mechanical polishing composition comprising:
(a) wet-process silica,
(b) a combination of
(i) an alcohol of formula (I): R¹-X-(CH₂)ₘ-OH wherein
R¹ is phenyl, pyridyl, HO-(CH₂)ₙ-, or C₁-C₆ alkyl,
m is an integer from 1 to 6,
n is an integer from 1 to 6, and
X is absent or is O, and
(ii) an alcohol of formula (II): R²-NR³-(CH₂)ₒ-OH wherein
R² is phenyl, pyridyl, H₂N-(CH₂)ₚ-, or C₁-C₆ alkyl,
R³ is hydrogen or C₁-C₆ alkyl,
o is an integer from 1 to 6, and
p is an integer from 1 to 6,
(c) hydrogen peroxide,
(d) a mineral acid, and
(e) water
wherein the polishing composition has a pH from 1 to 5
(iv) contacting the substrate with the polishing pad and the chemical-mechanical polishing composition, and
(v) moving the polishing pad and the chemical mechanical polishing composition relative to the substrate to abrade at least a portion of the substrate to polish the substrate.

10. The method of claim 9, wherein one or more of the following applies:
i) the wet-process silica has a particle size of 5 nm to 25 nm;
ii) the alcohol of formula (I) is phenoxyethanol, ethylene glycol monobutyl ether, or benzyl alcohol;
iii) the alcohol of formula (II) is aminoethylaminoethanol;
iv) the polishing composition comprises 1000 ppm to 10,000 ppm of the alcohol of formula (1) and 100 ppm to 1000 ppm of the alcohol of formula (II); and
v) the substrate is a nickel-phosphorous-coated aluminum memory disk, and wherein at least a portion of the nickel-phosphorous is abraded to polish the substrate.

11. A method of chemically mechanically polishing a substrate comprising:
(i) providing a substrate,
(ii) providing a polishing pad,
(iii) providing a chemical-mechanical polishing composition comprising:
(a) wet-process silica,
(b) phenoxyethanol, ethylene glycol monobutyl ether, or benzyl alcohol,
(c) hydrogen peroxide,
(d) a mineral acid, and
(e) water,
wherein the polishing composition has a pH from 1 to 5
(iv) contacting the substrate with the polishing pad and the chemical-mechanical polishing composition, and
(v) moving the polishing pad and the chemical mechanical polishing composition relative to the substrate to abrade at least a portion of the substrate to polish the substrate.

12. The method of claim 11, wherein the wet-process silica has a particle size of 5 nm to 25 nm.

13. The method of claim 11, wherein the polishing composition further comprises an alcohol of formula (II): R²-NR³-(CH₂)ₒ-OH wherein R² is phenyl, pyridyl, H₂N-(CH₂)ₚ- , or C₁-C₆ alkyl, R³ is hydrogen or C₁-C₆ alkyl, o is an integer from 1 to 6, and p is an integer from 1 to 6; and wherein optionally one or more of the following applies:
i) the alcohol of formula (II) is aminoethylaminoethanol; and/ or
ii) the polishing composition comprises 1000 ppm to 10,000 ppm of the alcohol of formula (III) and 100 ppm to 1000 ppm of the alcohol of formula (II).

14. The method of claim 11, wherein the substrate is a nickel-phosphorous-coated aluminum memory disk, and wherein at least a portion of the nickel-phosphorous is abraded to polish the substrate.

## Patentansprüche

1. Zusammensetzung zum chemisch-mechanischen Polieren, umfassend:
(a) Nassverfahren-Siliciumdioxid,
(b) eine Kombination von
(i) einem Alkohol der Formel (I) : R¹-X-(CH₂)ₘ-OH, wobei
R¹ für Phenyl, Pyridyl, HO-(CH₂)ₙ- oder C₁-C₆-Alkyl steht,
m für eine ganze Zahl von 1 bis 6 steht,
n für eine ganze Zahl von 1 bis 6 steht und
X fehlt oder für O steht, und
(ii) einem Alkohol der Formel (II) : R²-NR³-(CH₂)ₒ-OH, wobei
R² für Phenyl, Pyridyl, H₂N-(CH₂)ₚ- oder C₁-C₆-Alkyl steht,
R³ für Wasserstoff oder C₁-C₆-Alkyl steht,
o für eine ganze Zahl von 1 bis 6 steht und
p für eine ganze Zahl von 1 bis 6 steht,
(c) Wasserstoffperoxid,
(d) eine Mineralsäure und
(e) Wasser,
wobei die Polierzusammensetzung einen pH-Wert von 1 bis 5 aufweist.

2. Polierzusammensetzung nach Anspruch 1, wobei das Nassverfahren-Siliciumdioxid eine Teilchengröße von 5 nm bis 25 nm aufweist.

3. Polierzusammensetzung nach Anspruch 2, wobei das Nassverfahren-Siliciumdioxid eine Teilchengröße von 5 nm bis 10 nm aufweist.

4. Polierzusammensetzung nach Anspruch 1, wobei es sich bei dem Alkohol der Formel (I) um Phenoxyethanol, Ethylenglykolmonobutylether oder Benzylalkohol handelt.

5. Polierzusammensetzung nach Anspruch 4, wobei es sich bei dem Alkohol der Formel (I) um Phenoxyethanol handelt.

6. Polierzusammensetzung nach Anspruch 1, wobei es sich bei dem Alkohol der Formel (II) um Aminoethylaminoethanol handelt.

7. Polierzusammensetzung nach Anspruch 1, wobei die Polierzusammensetzung 1000 ppm bis 10.000 ppm des Alkohols der Formel (I) und 100
ppm bis 1000 ppm des Alkohols der Formel (II) umfasst.

8. Polierzusammensetzung nach Anspruch 1, wobei die Polierzusammensetzung einen pH-Wert von 1 bis 2 aufweist.

9. Verfahren zum chemisch-mechanischen Polieren eines Substrats, umfassend:
(i) Bereitstellen eines Substrats,
(ii) Bereitstellen eines Polierkissens,
(iii) Bereitstellen einer Zusammensetzung zum chemisch-mechanischen Polieren, umfassend:
(a) Nassverfahren-Siliciumdioxid,
(b) eine Kombination von
(i) einem Alkohol der Formel (I) : R¹-X-(CH₂)ₘ-OH, wobei
R¹ für Phenyl, Pyridyl, HO-(CH₂)ₙ- oder C₁-C₆-Alkyl steht,
m für eine ganze Zahl von 1 bis 6 steht,
n für eine ganze Zahl von 1 bis 6 steht und
X fehlt oder für O steht, und
(ii) einem Alkohol der Formel (II) : R²-NR³-(CH₂)ₒ-OH, wobei
R² für Phenyl, Pyridyl, H₂N-(CH₂)ₚ- oder C₁-C₆-Alkyl steht,
R³ für Wasserstoff oder C₁-C₆-Alkyl steht,
o für eine ganze Zahl von 1 bis 6 steht
und p für eine ganze Zahl von 1 bis 6 steht,
(c) Wasserstoffperoxid,
(d) eine Mineralsäure und
(e) Wasser,
wobei die Polierzusammensetzung einen pH-Wert von 1 bis 5 aufweist.
(iv) Inkontaktbringen des Substrats mit den Polierkissen und der Zusammensetzung zum chemisch-mechanischen Polieren und
(v) Bewegen des Polierkissens und der Zusammensetzung zum chemisch-mechanischen Polieren relativ zum Substrat zum Abtragen mindestens eines Teils des Substrats zum Polieren des Substrats.

10. Verfahren nach Anspruch 9, wobei eine oder mehrere der folgenden Aussagen zutreffen:
i) das Nassverfahren-Siliciumdioxid hat eine Teilchengröße von 5 nm bis 25 nm;
ii) bei dem Alkohol der Formel (I) handelt es sich um Phenoxyethanol, Ethylenglykolmonobutylether oder Benzylalkohol;
iii) bei dem Alkohol der Formel (II) handelt es sich um Aminoethylaminoethanol;
iv) die Polierzusammensetzung umfasst 1000 ppm bis 10.000 ppm des
Alkohols der Formel (I) und 100 ppm bis 1000 ppm des Alkohols der Formel(II);
und
v) bei dem Substrat handelt es sich um eine mit Nickel-Phosphor beschichtete Aluminium-Speicherplatte, wobei mindestens ein Teil des Nickel-Phosphors zum Polieren des Substrats abgetragen wird.

11. Verfahren zum chemisch-mechanischen Polieren eines Substrats, umfassend:
(i) Bereitstellen eines Substrats,
(ii) Bereitstellen eines Polierkissens,
(iii) Bereitstellen einer Zusammensetzung zum chemisch-mechanischen Polieren, umfassend:
(a) Nassverfahren-Siliciumdioxid,
(b) Phenoxyethanol, Ethylenglykolmonobutylether oder Benzylalkohol,
(c) Wasserstoffperoxid,
(d) eine Mineralsäure und
(e) Wasser,
wobei die Polierzusammensetzung einen pH-Wert von 1 bis 5 aufweist.
(iv) Inkontaktbringen des Substrats mit den Polierkissen und der Zusammensetzung zum chemisch-mechanischen Polieren und
(v) Bewegen des Polierkissens und der Zusammensetzung zum chemisch-mechanischen Polieren relativ zum Substrat zum Abtragen mindestens eines Teils des Substrats zum Polieren des Substrats.

12. Verfahren nach Anspruch 11, wobei das Nassverfahren-Siliciumdioxid eine Teilchengröße von 5 nm bis 25 nm aufweist.

13. Verfahren nach Anspruch 11, wobei die Polierzusammensetzung ferner einen Alkohol der Formel (II) umfasst: R²-NR³-(CH₂)ₒ-OH, wobei R² für Phenyl, Pyridyl, H₂N-(CH₂)ₚ- oder C₁-C₆-Alkyl steht, R³ für Wasserstoff oder C₁-C₆-Alkyl steht, o für eine ganze Zahl von 1 bis 6 steht und p für eine ganze Zahl von 1 bis 6 steht; und wobei gegebenenfalls eine oder mehrere der folgenden Aussagen zutreffen:
i) bei dem Alkohol der Formel (II) handelt es sich um Aminoethylaminoethanol; und/oder
ii) die Polierzusammensetzung umfasst 1000 ppm bis 10.000 ppm des
Alkohols der Formel (III) und 100 ppm bis 1000 ppm des Alkohols der Formel (II).

14. Verfahren nach Anspruch 11, wobei es sich bei dem Substrat um eine mit Nickel-Phosphor beschichtete Aluminium-Speicherplatte handelt und wobei mindestens ein Teil des Nickel-Phosphors zum Polieren des Substrats abgetragen wird.

## Revendications

1. Composition de polissage mécano-chimique comprenant :
(a) une silice issue d'un processus par voie humide,
(b) une combinaison de
(i) un alcool de formule (I) : R¹-X-(CH₂)ₘ-OH,
R¹ étant phényle, pyridinyle, HO-(CH₂)ₙ-, ou C₁-C₆ alkyle,
m étant un entier de 1 à 6,
n étant un entier de 1 à 6, et
X étant absent ou étant O, et
(ii) un alcool de formule (II) : R²-NR³-(CH₂)ₒ-OH,
R² étant phényle, pyridinyle, H₂N-(CH₂)ₚ-, ou C₁-C₆ alkyle, R³ étant hydrogène ou C₁-C₆ alkyle,
o étant un entier de 1 à 6, et
p étant un entier de 1 à 6,
(c) du peroxyde d'hydrogène,
(d) un acide minéral, et
(e) de l'eau,
la composition de polissage ayant un pH de 1 à 5.

2. Composition de polissage selon la revendication 1, la silice issue d'un processus par voie humide ayant une taille de particule de 5 nm à 25 nm.

3. Composition de polissage selon la revendication 2, la silice issue d'un processus par voie humide ayant une taille de particule de 5 nm à 10 nm.

4. Composition de polissage selon la revendication 1, l'alcool de formule (I) étant le phénoxyéthanol, l'éther de monobutyle d'éthylène glycol ou l'alcool benzylique.

5. Composition de polissage selon la revendication 4, l'alcool de formule (I) étant le phénoxyéthanol.

6. Composition de polissage selon la revendication 1, l'alcool de formule (II) étant l'aminoéthylaminoéthanol.

7. Composition de polissage selon la revendication 1, la composition de polissage comprenant 1 000 ppm à 10 000 ppm de l'alcool de formule (I) et 100 ppm à 1 000 ppm de l'alcool de formule (II).

8. Composition de polissage selon la revendication 1, la composition de polissage ayant un pH de 1 à 2.

9. Procédé de polissage mécano-chimique d'un substrat comprenant :
(i) la fournitures d'un substrat,
(ii) la fourniture d'un tampon de polissage,
(iii) la fourniture d'une composition de polissage mécano-chimique comprenant :
(a) une silice issue d'un processus par voie humide,
(b) une combinaison de
(i) un alcool de formule (I) : R¹-X-(CH₂)ₘ-OH,
R¹ étant phényle, pyridinyle, HO-(CH₂)ₙ-, ou C₁-C₆ alkyle,
m étant un entier de 1 à 6,
n étant un entier de 1 à 6, et
X étant absent ou étant O, et
(ii) un alcool de formule (II) : R²-NR³-(CH₂)ₒ-OH,
R² étant phényle, pyridinyle, H₂N-(CH₂)ₚ-, ou C₁-C₆ alkyle,
R³ étant hydrogène ou C₁-C₆ alkyle,
o étant un entier de 1 à 6, et
p étant un entier de 1 à 6,
(c) du peroxyde d'hydrogène,
(d) un acide minéral, et
(e) de l'eau
la composition de polissage ayant un pH de 1 à 5
(iv) la mise en contact du substrat avec le tampon de polissage et la composition de polissage mécano-chimique, et
(v) le déplacement du tampon de polissage et de la composition de polissage mécano-chimique par rapport au substrat pour abraser au moins une partie du substrat pour polir le substrat.

10. Procédé selon la revendication 9, l'un ou plusieurs des énoncés suivants s'appliquant :
i) la silice issue d'un processus par voie humide a une taille de particule de 5 nm à 25 nm ;
ii) l'alcool de formule (I) est le phénoxyéthanol, l'éther de monobutyle d'éthylène glycol ou l'alcool benzylique ;
iii) l'alcool de formule (II) est l'aminoéthylaminoéthanol ;
iv) la composition de polissage comprend 1 000 ppm à 10 000 ppm de l'alcool de formule (I) et 100 ppm à 1 000 ppm de l'alcool de formule (II) ;
et
v) le substrat est un disque mémoire d'aluminium revêtu par du nickel-phosphore, et au moins une partie du nickel-phosphoreux étant abrasée pour polir le substrat.

11. Procédé de polissage mécano-chimique d'un substrat comprenant :
(i) la fournitures d'un substrat,
(ii) la fourniture d'un tampon de polissage,
(iii) la fourniture d'une composition de polissage mécano-chimique comprenant :
(a) une silice issue d'un processus par voie humide,
(b) du phénoxyéthanol, de l'éther de monobutyle d'éthylène glycol ou de l'alcool benzylique,
(c) du peroxyde d'hydrogène,
(d) un acide minéral, et
(e) de l'eau,
la composition de polissage ayant un pH de 1 à 5
(iv) la mise en contact du substrat avec le tampon de polissage et la composition de polissage mécano-chimique, et
(v) le déplacement du tampon de polissage et de la composition de polissage mécano-chimique par rapport au substrat pour abraser au moins une partie du substrat pour polir le substrat.

12. Procédé selon la revendication 11, la silice issue d'un processus par voie humide ayant une taille de particule de 5 nm à 25 nm.

13. Procédé selon la revendication 11, la composition de polissage comprenant en outre un alcool de formule (II) : R²-NR³-(CH₂)ₒ-OH, R² étant phényle, pyridinyle, H₂N-(CH₂)ₚ- , ou C₁-C₆ alkyle, R³ étant hydrogène ou C₁-C₆ alkyle, o étant un entier de 1 à 6, et p étant un entier de 1 à 6 ; et éventuellement l'un ou plusieurs des énoncés suivants s'appliquant :
i) l'alcool de formule (II) est l'aminoéthylaminoéthanol ; et/ou
ii) la composition de polissage comprend 1 000 ppm à 10 000 ppm de l'alcool de formule (III) et 100 ppm à 1 000 ppm de l'alcool de formule (II).

14. Procédé selon la revendication 11, le substrat étant un disque mémoire d'aluminium revêtu par du nickel-phosphore, et au moins une partie du nickel-phosphore étant abrasée pour polir le substrat.
